(19) Europäisches Patentamt
European Patent Office
Office européen des brevets

(11) EP 4 270 107 A1

(12) # EUROPEAN PATENT APPLICATION
published in accordance with Art. 153(4) EPC

(43) Date of publication:
**01.11.2023 Bulletin 2023/44**

(21) Application number: **21910854.5**

(22) Date of filing: **22.12.2021**

(51) International Patent Classification (IPC):
***G03F 7/00*** *(2006.01)* ***G03F 7/095*** *(2006.01)*

(52) Cooperative Patent Classification (CPC):
**G03F 7/00; G03F 7/095**

(86) International application number:
**PCT/JP2021/047547**

(87) International publication number:
**WO 2022/138714 (30.06.2022 Gazette 2022/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.12.2020 JP 2020212546**

(71) Applicant: **FUJIFILM Corporation**
**Tokyo 106-8620 (JP)**

(72) Inventor: **WATANABE, Kazuki**
**Haibara-gun, Shizuoka 421-0396 (JP)**

(74) Representative: **HGF**
**HGF Limited**
**1 City Walk**
**Leeds LS11 9DX (GB)**

(54) **FLEXOGRAPHIC PRINTING PLATE ORIGINAL PLATE AND METHOD FOR MANUFACTURING FLEXOGRAPHIC PRINTING PLATE**

(57) An object of the present invention is to provide a flexographic printing plate precursor in which a sensitivity of a heat-sensitive image forming layer is high and occurrence of white spots in a line drawing can be suppressed in a case of being used for a flexographic printing plate, and a manufacturing method of a flexographic printing plate using the same. The flexographic printing plate precursor of the present invention is a flexographic printing plate precursor including, in the following order, a support, a photosensitive resin layer, a barrier layer, and a heat-sensitive image forming layer, in which the barrier layer contains a first infrared absorbing dye, the heat-sensitive image forming layer contains an ultraviolet absorber and a second infrared absorbing dye, and in the barrier layer, a content of a compound having substantially no absorption in a wavelength range of 900 to 1200 nm and having an absorption in a wavelength range of 300 to 400 nm is 0% by mass or more and less than 0.1% by mass with respect to a mass of the barrier layer.

EP 4 270 107 A1

## Description

## BACKGROUND OF THE INVENTION

1. Field of the Invention

The present invention relates to a flexographic printing plate precursor and a manufacturing method of a flexographic printing plate using the same.

2. Description of the Related Art

A precursor of a flexographic printing plate generally includes a photosensitive resin layer formed of a photosensitive resin composition on a support formed of a polyester film or the like. The flexographic printing plate is formed by exposing a surface of the photosensitive resin layer of the precursor to a predetermined image and then removing a resin in a portion not exposed.

In a so-called analog-type flexographic printing plate precursor, a negative film on which the predetermined image is already formed is placed on the photosensitive resin layer, and the predetermined image is exposed on the surface of the photosensitive resin layer through this negative film.

On the other hand, in a laser ablation mask (LAM)-type flexographic printing plate precursor, a heat-sensitive image forming layer (infrared ablation layer) is provided in advance on the photosensitive resin layer, an infrared laser is used to draw digitized negative image information directly onto the heat-sensitive image forming layer to produce a desired negative pattern, and then the predetermined image is exposed on the surface of the photosensitive resin layer through this negative pattern.

As such a LAM-type flexographic printing plate precursor, for example, JP2012-137515A discloses a flexographic printing plate precursor in which a support, a photosensitive resin layer, and an infrared ablation layer containing a binder polymer and an infrared absorbing substance are laminated.

## SUMMARY OF THE INVENTION

As a result of studying the flexographic printing plate precursor disclosed in JP2012-137515A, the present inventors have found that there is room for improvement in sensitivity of the drawing formed on the heat-sensitive image forming layer (infrared ablation layer).

In addition, the present inventors have found that, in a case where a fine line pattern is formed as an image area which is formed on the photosensitive resin layer using an ultraviolet (UV) exposure machine with high illuminance, white spots occur in a printed line drawing.

An object of the present invention is to provide a flexographic printing plate precursor in which a sensitivity of a heat-sensitive image forming layer is high and occurrence of white spots in a line drawing can be suppressed in a case of being used for a flexographic printing plate, and a manufacturing method of a flexographic printing plate using the same.

As a result of intensive studies to achieve the above-described object, the present inventors have found that, in a case where both of a barrier layer and a heat-sensitive image forming layer contain an infrared absorbing dye and a content of a compound having substantially no absorption in a wavelength range of 900 to 1200 nm and having an absorption in a wavelength range of 300 to 400 nm, which can be contained in the barrier layer, is 0% by mass or more and less than 0.1% by mass with respect to a mass of the barrier layer, the sensitivity of the heat-sensitive image forming layer is high, and the occurrence of white spots in the line drawing can be suppressed in a case of being used for a flexographic printing plate, and have completed the present invention.

That is, the present inventors have found that the above-described object can be achieved by adopting the following configurations.

[1] A flexographic printing plate precursor comprising, in the following order:

a support;
a photosensitive resin layer;
a barrier layer; and
a heat-sensitive image forming layer,
in which the barrier layer contains a first infrared absorbing dye,
the heat-sensitive image forming layer contains an ultraviolet absorber and a second infrared absorbing dye, and
in the barrier layer, a content of a compound having substantially no absorption in a wavelength range of 900

to 1200 nm and having an absorption in a wavelength range of 300 to 400 nm is 0% by mass or more and less than 0.1% by mass with respect to a mass of the barrier layer.

[2] The flexographic printing plate precursor according to [1],
in which both of the first infrared absorbing dye and the second infrared absorbing dye are a compound having an absorption at a wavelength of 1070 nm and having a mass absorption coefficient at the wavelength of 1070 nm of 50 L/(g cm) or more.
[3] The flexographic printing plate precursor according to [2],
in which both of the first infrared absorbing dye and the second infrared absorbing dye are a compound represented by Formula (1) described later.
[4] The flexographic printing plate precursor according to [2] or [3],
in which both of the barrier layer and the heat-sensitive image forming layer contain a third infrared absorbing dye having an absorption at a wavelength of 830 nm.
[5] The flexographic printing plate precursor according to any one of [1] to [4],

in which the photosensitive resin layer contains a monomer, a polymerization initiator, a base polymer, and water-dispersible particles,
the water-dispersible particles have a carbon-carbon double bond, and
a carbon-carbon double bond amount on a surface of the water-dispersible particles is 21 or less.

[6] A manufacturing method of a flexographic printing plate having a non-image area and an image area, the manufacturing method comprising:

a mask forming step of, with respect to the flexographic printing plate precursor according to any one of [1] to [4], forming an image on the heat-sensitive image forming layer included in the flexographic printing plate precursor to form a mask;
an exposure step of, after the mask forming step, imagewise exposing the photosensitive resin layer included in the flexographic printing plate precursor through the mask; and
a development step of, after the exposure step, performing development using a developer to form a non-image area and an image area.

[7] The manufacturing method of a flexographic printing plate according to [6],
in which the developer contains 50% by mass or more of water.
[8] The manufacturing method of a flexographic printing plate according to [6] or [7],
in which the developer contains a surfactant represented by Formula (2) described later.

According to the present invention, it is possible to provide a flexographic printing plate precursor in which a sensitivity of a heat-sensitive image forming layer is high and occurrence of white spots in a line drawing can be suppressed in a case of being used for a flexographic printing plate, and a manufacturing method of a flexographic printing plate using the same.

**BRIEF DESCRIPTION OF THE DRAWINGS**

Fig. 1 is a schematic cross-sectional view showing an example of a flexographic printing plate precursor according to the embodiment of the present invention.
Fig. 2A is a schematic cross-sectional view showing one step in an example of a manufacturing method of a flexographic printing plate according to the embodiment of the present invention.
Fig. 2B is a schematic cross-sectional view showing one step in the example of the manufacturing method of a flexographic printing plate according to the embodiment of the present invention.
Fig. 2C is a schematic cross-sectional view showing one step in the example of the manufacturing method of a flexographic printing plate according to the embodiment of the present invention.
Fig. 2D is a schematic cross-sectional view showing one step in the example of the manufacturing method of a flexographic printing plate according to the embodiment of the present invention.
Fig. 3A is a schematic cross-sectional view showing one step in an example of a manufacturing method of a flexographic printing plate in the related art.
Fig. 3B is a schematic cross-sectional view showing one step in the example of the manufacturing method of a

flexographic printing plate in the related art.

Fig. 3C is a schematic cross-sectional view showing one step in the example of the manufacturing method of a flexographic printing plate in the related art.

Fig. 3D is a schematic cross-sectional view showing one step in the example of the manufacturing method of a flexographic printing plate in the related art.

## DESCRIPTION OF THE PREFERRED EMBODIMENTS

Hereinafter, the present invention will be described in detail.

The description of configuration requirements described below may be made on the basis of representative embodiments of the present invention, but it should not be construed that the present invention is limited to those embodiments.

In the specification of the present application, the numerical range expressed by using "to" means a range including the numerical values before and after "to" as the lower limit value and the upper limit value.

In addition, in this specification, for each component, one kind of substance corresponding to each component may be used alone, or two or more kinds thereof may be used in combination. Here, in a case where two or more kinds of substances are used in combination for each component, the content of the component indicates the total content of the substances used in combination, unless otherwise specified.

[Flexographic printing plate precursor]

The flexographic printing plate precursor according to the embodiment of the present invention is a flexographic printing plate precursor including, in the following order, a support, a photosensitive resin layer, a barrier layer, and a heat-sensitive image forming layer.

In addition, the above-described barrier layer contains a first infrared absorbing dye.

In addition, the above-described heat-sensitive image forming layer contains an ultraviolet absorber and a second infrared absorbing dye.

In addition, in the above-described barrier layer, a content of a compound having substantially no absorption in a wavelength range of 900 to 1200 nm and having an absorption in a wavelength range of 300 to 400 nm (hereinafter, also abbreviated as "UV absorbing impurity") is 0% by mass or more and less than 0.1% by mass with respect to a mass of the above-described barrier layer.

Fig. 1 is a schematic cross-sectional view showing an example of the flexographic printing plate precursor according to the embodiment of the present invention.

A flexographic printing plate precursor 10 shown in Fig. 1 includes a support 1, a photosensitive resin layer 2, a barrier layer 3, and a heat-sensitive image forming layer 4 in this order.

In addition, as shown in Fig. 1, the flexographic printing plate precursor according to the embodiment of the present invention may include a cover sheet 5.

In the present invention, as described above, in a case where both of the barrier layer and the heat-sensitive image forming layer contain an infrared absorbing dye and the content of the UV absorbing impurity which can be contained in the barrier layer is 0% by mass or more and less than 0.1% by mass with respect to the mass of the barrier layer, the sensitivity of the heat-sensitive image forming layer is high, and the occurrence of white spots in the line drawing can be suppressed in a case of being used for a flexographic printing plate.

Although the details thereof are not clear, the present inventors have presumed as follows.

First, the reason why the sensitivity of the heat-sensitive image forming layer is high is that, by formulating, as an infrared absorbing substance, a dye having a small particle size instead of a pigment such as carbon black, ablation by infrared rays is likely to proceed.

On the other hand, it is considered that the white spots in the line drawing occur due to the following causes.

That is, as shown in Figs. 3A to 3D, in a case where the barrier layer is not included, a residue 4a of the heat-sensitive image forming layer is generated in forming an image on the heat-sensitive image forming layer 4 (see Fig. 3B). Thereafter, in a case where the photosensitive resin layer 2 is exposed, an exposed portion 2c and a weakly exposed portion 2d are generated due to the influence of the residue 4a (see Fig. 3C). Thereafter, since the image area is formed in a state in which an end part 2e of the exposed portion 2c is raised by development (see Fig. 3D), it is considered that it is difficult to apply pressure to a central portion of the line drawing to be printed, resulting in white spots. Since the white spots are apparent in a case of using an UV exposure machine with high illuminance, it is considered that this is because a monomer component in the weakly exposed portion 2d migrates to the end part of the exposed portion 2c during the exposure.

On the other hand, as shown in Figs. 2A to 2D, in a case of using the flexographic printing plate precursor according to the embodiment of the present invention, the existence of the barrier layer 3 can suppress the generation

of the residue of the heat-sensitive image forming layer 4. In addition, with regard to a residue 3a of the barrier layer, since the content of the UV absorbing impurity which can be contained in the barrier layer is extremely small, it is considered that, in the subsequent exposure step, only the exposed portion 2b is formed and the weakly exposed portion is not formed, so that the white spots in the line drawing are suppressed.

In Figs. 2A to 2D and Figs. 3A to 3D, since back exposure from the support 1 side is performed before forming an image on the heat-sensitive image forming layer 4, a floor 2a is formed on the photosensitive resin layer 2.

Hereinafter, the infrared absorbing dye will be described in detail, and then each layer configuration of the flexographic printing plate precursor according to the embodiment of the present invention will be described in detail.

[First infrared absorbing dye and second infrared absorbing dye]

The first infrared absorbing dye contained in the barrier layer and the second infrared absorbing dye contained in the heat-sensitive image forming layer are not particularly limited as long as they are solvent-soluble coloring agents, and examples thereof include a nitroso compound and a metal complex salt thereof, a polymethine-based coloring agent (cyanine coloring agent), a squarylium-based coloring agent, a thiolnickel complex salt, a phthalocyanine-based coloring agent, a triallylmethane-based coloring agent, an immonium-based coloring agent, a diimmonium-based coloring agent, a naphthoquinone-based coloring agent, and an anthraquinone-based coloring agent.

In addition, from the viewpoint of excellent developability with an aqueous developer and less contamination of a developing machine, it is preferable to use a water-soluble coloring agent, and from the viewpoint of being able to select a dye which has a wide range of structure options and has durability, it is preferable to use a coloring agent which is soluble in an organic solvent.

In the present invention, from the reason that the sensitivity of the heat-sensitive image forming layer is increased, it is preferable that both of the first infrared absorbing dye and the second infrared absorbing dye are a compound (hereinafter, also abbreviated as "specific dye") having an absorption at a wavelength of 1070 nm and having a mass absorption coefficient at the wavelength of 1070 nm of 50 L/(g·cm) or more.

In addition, the above-described specific dye has a mass absorption coefficient of more preferably 50 to 200 L/(g·cm) and still more preferably 50 to 100 L/(g·cm).

Here, the mass absorption coefficient refers to a value calculated by the following method.

First, 10 mg of the infrared absorbing dye to be measured is diluted with 1 L of methyl ethyl ketone to obtain a measurement solution.

Next, an absorption spectrum of the obtained measurement liquid is measured for an infrared absorption range (200 nm to 3300 nm). As a measuring device, UH4150 manufactured by Hitachi High-Tech Science Corporation is used.

Next, the mass absorption coefficient at the wavelength of 1070 nm is obtained from the obtained absorption spectrum (unit: L/g·cm). Specifically, a transmittance T (%) at a cell length L (cm) in a solution having a designated concentration C (g/L) is measured, and a mass absorption coefficient k is calculated from the following expression.

$$\text{Mass absorption coefficient } k = A/CL \text{ (unit: L/(g·cm))}$$

$$\text{Absorbance } A = -\log_{10}(T)$$

In the present invention, from the reason that the sensitivity of the heat-sensitive image forming layer is further increased, it is preferable that the above-described specific dye as the first infrared absorbing dye and the second infrared absorbing dye is a compound represented by Formula (1).

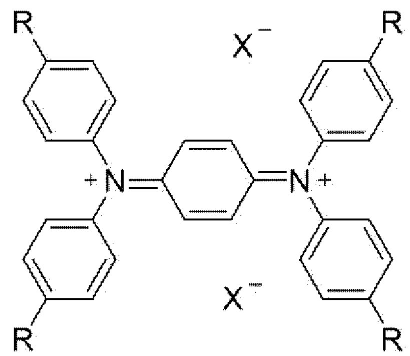

(1)

In Formula (1), R represents a monovalent organic group, in which a plurality of R's may be the same or different from each other.

In addition, in Formula (1), $X^-$ represents a monovalent anion, in which a plurality of $X^-$'s may be the same or different from each other.

Examples of the monovalent organic group represented by R in Formula (1) include an alkyl group, a cycloalkyl group, an aryl group, an aralkyl group, an alkenyl group, and $-NR^{11}R^{12}$ ($R^{11}$ and $R^{12}$ each independently represent a hydrogen atom or a hydrocarbon group), and these groups may further have a substituent.

Examples of the alkyl group include a linear or branched alkyl group having 1 to 18 carbon atoms, and specific examples thereof include a methyl group, an ethyl group, a propyl group, a butyl group, a pentyl group, a tert-pentyl group, and an n-hexyl group.

Examples of the cycloalkyl group include a monocyclic or polycyclic cycloalkyl group having 3 to 20 carbon atoms, and specific examples thereof include a cyclopentyl group, a cyclopentylmethyl group, a cyclopentylethyl group, a cyclohexyl group, a cyclohexylmethyl group, and a cyclohexylethyl group.

Examples of the aryl group include an aryl group having 6 to 14 carbon atoms, and specific examples thereof include a phenyl group, a methylphenyl group, a tolyl group, a xylyl group, a naphthyl group, an anthryl group, a phenanthryl group, and a pyrenyl group.

Examples of the aralkyl group include an aralkyl group having 7 to 20 carbon atoms, and specific examples thereof include a benzyl group, a phenethyl group, a 2-phenylethan-2-yl group, and a naphthylmethyl group.

Examples of the alkenyl group include an alkenyl group having 3 to 20 carbon atoms, and specific examples thereof include a vinyl group and an allyl group.

Examples of the hydrocarbon group represented as one aspect of $R^{11}$ and $R^{12}$ include the above-described alkyl group and the above-described aryl group.

Examples of the monovalent anion represented by $X^-$ in Formula (1) include $ClO_4^-$, $PF_6^-$, $BF_4^-$, and a bis(trifluoromethanesulfonyl)imide anion represented by the following formula.

In addition, as the monovalent anion of $X^-$, anions described in paragraphs [0016] to [0023] of JP2011-38007A can also be used.

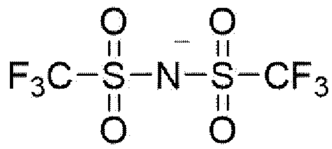

[Third infrared absorbing dye]

In the present invention, in a case where the first infrared absorbing dye and the second infrared absorbing dye are the above-described specific dyes, from the reason that the sensitivity of the heat-sensitive image forming layer is increased, it is preferable that both of the barrier layer and the heat-sensitive image forming layer further contain a third infrared absorbing dye having an absorption at a wavelength of 830 nm.

Here, as the third infrared absorbing dye, a dye having an absorption at a wavelength of 830 nm can be appropriately selected and used from known infrared absorbing dyes, and examples thereof include an azo dye, a squarylium dyes, a croconate dye, a triarylamine dye, a thiazolium dyes, an indolium dyes, an oxonol dye, an oxazolium dye, a cyanine dye, a merocyanine dye, a phthalocyanine dye, an indocyanine dye, an indotricarbocyanine dye, an oxatricarbocyanine dyes, a thiocyanine dye, a thiatricarbocyanine dye, a merocyanine dye, a cryptocyanine dye, a naphthalocyanine dye, a polyaniline dye, a polypyrrole dye, a polythiophene dye, a chalcogenopyryloarylidene and bi(chalcogenopyryllo)polymethine dye, an oxindolizine dye, a pyrylium dye, a pyrazoline azo dye, an oxazine dye, a naphthoquinone dye, an anthraquinone dye, a quinoneimine dye, a methine dye, an arylmethine dye, a squaraine dye, an oxazole dye, a croconine dye, a porphyrin dye, and substituted or ionic forms of any of these dyes.

From the reason that the effects of the present invention are more excellent, the third infrared absorbing dye is preferably a cyanine dye, and more preferably a closed-type cyanine dye. Examples of such a dye include IR-813 (p-toluenesulfonate) (manufactured by Tokyo Chemical Industry Co., Ltd.).

[Barrier layer]

The barrier layer included in the flexographic printing plate precursor according to the embodiment of the present invention is a layer containing the above-described first infrared absorbing dye, and is a layer which functions as an infrared ablation layer together with the heat-sensitive image forming layer described later.

In addition, the barrier layer is a layer in which a content of the UV absorbing impurity which can be contained

in the barrier layer is 0% by mass or more and less than 0.1% by mass with respect to the mass of the barrier layer.

<Content of first infrared absorbing dye>

The content of the above-described first infrared absorbing dye contained in the barrier layer is preferably 2% to 75% by mass and more preferably 5% to 70% by mass with respect to the mass of the barrier layer, that is, the total mass of solid contents of a composition used for formation.

<UV absorbing impurity>

As described above, the UV absorbing impurity which can be contained in the barrier layer is a compound having substantially no absorption in a wavelength range of 900 to 1200 nm and having an absorption in a wavelength range of 300 to 400 nm.

Here, the "substantially having no absorption" refers to that an absorbance of the UV absorbing impurity in a 1.0 g/liter dichloromethane solution at a cell length of 1 cm is 5.0 or less, preferably 2.0 or less and more preferably 0 to 1.0.

In addition, the content of the UV absorbing impurity is 0% by mass or more and less than 0.1% by mass, but it is preferably 0% by mass, that is, it is preferable that the UV absorbing impurity is not contained.

<Thermally decomposable compound>

The barrier layer preferably contains a thermally decomposable compound as a binder.

Examples of the thermally decomposable compound include ammonium nitrate, potassium nitrate, sodium nitrate, nitrocellulose, polyvinylpyrrolidone, an azo compound, a diazo compound, a hydrazine derivative, an acrylic resin, a metal, and a metal oxide.

Among these, from the viewpoint of solution coatability, a polymer compound is preferable, and polyvinylpyrrolidone, nitrocellulose, or an acrylic resin is more preferable.

A content of the thermally decomposable compound is preferably 80% by mass or less and more preferably 15% to 60% by mass with respect to the mass of the barrier layer, that is, the total mass of solid contents of a composition used for formation.

A film thickness of the barrier layer is preferably 0.1 to 6 μm and more preferably 0.2 to 3 μm.

[Heat-sensitive image forming layer]

The heat-sensitive image forming layer included in the flexographic printing plate precursor according to the embodiment of the present invention is a layer containing an ultraviolet absorber and the above-described second infrared absorbing dye, and is a layer which functions as the infrared ablation layer.

<Content of second infrared absorbing dye>

A content of the above-described second infrared absorbing dye contained in the heat-sensitive image forming layer is preferably 2% to 75% by mass and more preferably 5% to 70% by mass with respect to the mass of the heat-sensitive image forming layer, that is, the total mass of solid contents of a composition used for formation.

<Ultraviolet absorber>

Suitable examples of the ultraviolet absorber contained in the heat-sensitive image forming layer include a compound having an absorption in a range of 300 nm to 400 nm.

Specific examples of the above-described compound include a benzotriazole-based compound, a triazine-based compound, a benzophenone-based compound, and carbon black.

In addition, specific examples of the above-described compound also include metal compounds such as iron powder, a diamine-based metal complex, a dithiol-based metal complex, a phenolthiol-based metal complex, a mercaptophenol-based metal complex, an aryl aluminum metal salt, a crystal water-containing inorganic compound, copper sulfate, chromium sulfide, and a silicate compound; and metal oxides such as titanium oxide, vanadium oxide, manganese oxide, iron oxide, cobalt oxide, and tungsten oxide.

Among these, it is preferable to use a benzophenone-based compound or carbon black.

A content of the ultraviolet absorber is preferably 0.1% to 75% by mass and more preferably 1% to 50% by mass with respect to the mass of the heat-sensitive image forming layer, that is, the total mass of solid contents of a composition used for formation.

<Thermally decomposable compound>

The heat-sensitive image forming layer preferably contains a thermally decomposable compound as a binder.
The thermally decomposable compound is the same as that described in the barrier layer, and the suitable examples thereof and the content thereof are also the same.
A film thickness of the heat-sensitive image forming layer is preferably 0.1 to 6 μm and more preferably 0.5 to 3 μm.

[Photosensitive resin layer]

The photosensitive resin layer included in the flexographic printing plate precursor according to the embodiment of the present invention is not particularly limited, and the photosensitive resin layer can be formed of a known photosensitive resin composition in the related art. For example, the photosensitive resin layer can be formed of a resin composition containing a water-dispersible latex, rubber, a photopolymerizable monomer, a photopolymerization initiator, and a surfactant.
In the present invention, from the reason that it is possible to further suppress the occurrence of white spots in the line drawing in a case of being used for a flexographic printing plate, it is preferable that the photosensitive resin layer contains a monomer, a polymerization initiator, a base polymer, and water-dispersible particles, in which the water-dispersible particles have a carbon-carbon double bond, and a carbon-carbon double bond amount on a surface of the water-dispersible particles is 21 or less. It is considered that this is because, in a case where the photosensitive resin layer is formed, fusion welding of the water-dispersible particles, which can occur during applying and drying, is suppressed, so that any unwanted image formation caused by the above-described weakly exposed portion can be removed by the development.
Such a photosensitive resin layer is described in paragraphs [0016] to [0044] of WO2020/158778A. The description of the above-described documents are incorporated in the present specification by reference.
A film thickness of the photosensitive resin layer is preferably 0.2 to 6 mm.

[Support]

A material used for the support included in the flexographic printing plate precursor according to the embodiment of the present invention is not particularly limited, and a support with high dimensional stability is preferably used. Examples thereof include metals such as steel, stainless steel, and aluminum; polyester (for example, polyethylene terephthalate (PET), polybutylene terephthalate (PBT), polyethylene naphthalate (PEN), polyimide (PI), polyamide, liquid crystal polymer (LCP), and polyacrylonitrile (PAN)); plastic resins such as polyvinyl chloride; synthetic rubber such as styrene-butadiene rubber; glass fiber reinforced plastic resin (such as epoxy resin and phenolic resin); and cloth and paper.
From the viewpoint of dimensional stability and availability, the support is preferably a polymer film or cloth, and more preferably a polymer film. The morphology of the support is determined by whether the polymer layer is sheet-like or sleeve-like.
As the cloth, plain or twill weave fabrics and various knitted fabrics of natural fibers such as cotton, linen, silk, and wool or synthetic fibers such as acetate, vinylon, vinylidene, polyvinyl chloride, acrylic, polypropylene, polyethylene, polyurethane, fluorine filament, polyclar, rayon, nylon, polyamide, and polyester, or nonwoven fabrics can be used.
Examples of the polymer film include a film formed of various polymers such as polyester (for example, polyethylene terephthalate (PET), polybutylene terephthalate (PBT), polyethylene naphthalate (PEN), polyimide (PI), polyamide, liquid crystal polymer (LCP), and polyacrylonitrile (PAN)), plastic resins such as polyvinyl chloride, synthetic rubber such as styrene-butadiene rubber, and glass fiber reinforced plastic resin (such as epoxy resin and phenolic resin). Among these, from the viewpoint of dimensional stability and the like, a polyester film is preferable.
Examples of the above-described polyester film include a PET film, a PBT film, and a PEN film, and from the viewpoint of dimensional stability and the like, a polyethylene terephthalate (PET) film is preferable.
A film thickness of the support is not particularly limited, but from the viewpoint of dimensional stability and handleability, it is preferably 5 to 3000 μm, more preferably 50 to 2000 μm, and still more preferably 100 to 1000 μm.

[Cover sheet]

As shown in Fig. 1, the flexographic printing plate precursor according to the embodiment of the present invention may include a cover sheet.
Such a cover sheet is not particularly limited, but is preferably a transparent polymer film and may be one layer alone or two or more layers laminated.

Here, the "transparent" in the present invention means that a transmittance of visible light is 60% or more, preferably 80% or more and particularly preferably 90% or more.

Examples of a material of the polymer film include cellulose-based polymers; acrylic polymers having an acrylic acid ester polymer such as polymethyl methacrylate and a lactone ring-containing polymer; thermoplastic norbornene-based polymers; polycarbonate-based polymers; polyester-based polymers such as polyethylene terephthalate, polyethylene naphthalate, and a fluoropolyester polymer; styrene-based polymers such as polystyrene and an acrylonitrile-styrene copolymer (AS resin); polyolefin-based polymers such as polyethylene, polypropylene, an ethylene-propylene copolymer, and polybutadiene; vinyl chloride-based polymers; amide-based polymers such as nylon and aromatic polyamide; imide-based polymers; sulfone-based polymers; polyether sulfone-based polymers; polyether ether ketone-based polymers; polyphenylene sulfide-based polymers; vinylidene chloride-based polymers; vinyl alcohol-based polymers; vinyl butyral-based polymers; arylate-based polymers; polyoxymethylene-based polymers; epoxy-based polymers; and polymers obtained by mixing these polymers.

In addition, a surface (surface on which the heat-sensitive image forming layer is formed) of the cover sheet may be subjected to peeling treatment for suppressing adhesion of the heat-sensitive image forming layer and enhancing peelability of the cover sheet. Examples of such a peeling treatment include a method of applying a peeling agent to the surface of the cover sheet to form a peeling layer. Examples of the peeling agent include a silicone-based peeling agent and an alkyl-based peeling agent.

A film thickness of the cover sheet is preferably 25 to 250 μm.

[Functional layer]

The flexographic printing plate precursor according to the embodiment of the present invention may include any functional layer between the above-described photosensitive resin layer and the above-described barrier layer.

The above-described functional layer is not particularly limited, but for the purpose of blocking atmospheric oxygen which may cause polymerization inhibition during UV exposure and suppressing mass transfer between the heat-sensitive image forming layer and the photosensitive resin layer, it is preferable to use a water-soluble polymer. Examples of the water-soluble polymer include polyvinyl alcohols, modified polyvinyl alcohols, polyvinylpyrrolidone, water-soluble cellulose derivatives, polyethylene glycol, poly(meth)acrylonitriles, and polyamides.

In addition, the functional layer may contain an additive within a range which does not adversely affect the performance.

Examples of the above-described additive include a plasticizer and various stabilizers.

In addition, in order to reduce the above-described defects of the functional layer, an additive such as an antifoaming agent and a leveling agent may be formulated as long as it does not adversely affect the performance.

[Manufacturing method of flexographic printing plate]

The manufacturing method of a flexographic printing plate according to the embodiment of the present invention is a manufacturing method of a flexographic printing plate having a non-image area and an image area, the manufacturing method including: a mask forming step of forming an image on the heat-sensitive image forming layer included in the above-described flexographic printing plate precursor according to the embodiment of the present invention to form a mask; an exposure step of, after the mask forming step, imagewise exposing the photosensitive resin layer included in the above-described flexographic printing plate precursor according to the embodiment of the present invention through the mask; and a development step of, after the exposure step, performing development using a developer to form a non-image area and an image area.

[Mask forming step]

The above-described mask forming step is a step of forming an image on the heat-sensitive image forming layer to form a mask to be used in the exposure step described later. As described above, since the above-described barrier layer included in the flexographic printing plate precursor according to the embodiment of the present invention is a layer which functions as an infrared ablation layer together with the heat-sensitive image forming layer, in a case where an image is formed on the heat-sensitive image forming layer, the image is simultaneously formed on the barrier layer.

Here, in the heat-sensitive image forming layer, in a case of being irradiated with an infrared laser, the action of the second infrared absorbing dye generates heat, which decomposes the thermally decomposable compound to remove, that is, to laser-ablate the heat-sensitive image forming layer.

Therefore, by selectively laser-ablating the heat-sensitive image forming layer based on the image data, it is possible to obtain an image mask capable of forming a latent image on the photosensitive resin layer.

For the infrared laser irradiation, an infrared laser having an oscillation wavelength in a range of 750 nm to 3000 nm is used.

Examples of such a laser include a solid-state laser such as a ruby laser, an Alexandrite laser, a perovskite laser, an Nd-YAG laser, and an emerald glass laser; a semiconductor laser such as InGaAsP, InGaAs, and GaAsAl; and a coloring agent laser such as a Rhodamine coloring agent.

In addition, a fiber laser which amplifies these light sources with a fiber can also be used.

Among these, from the viewpoint that the sensitivity of the heat-sensitive image forming layer is increased, it is preferable to use an exposure light source having an oscillation wavelength of 900 to 1200 nm, and it is more preferable to use a fiber laser.

[Exposure step]

The above-described exposure step is a step of imagewise exposing the photosensitive resin layer through the mask obtained in the above-described mask forming step, and by imagewise irradiating the photosensitive resin layer with ultraviolet rays, crosslinking and/or polymerization of regions irradiated with the ultraviolet rays can be induced to be cured.

[Development step]

The above-described development step is a step of performing development using a developer to form a non-image area and an image area.

The developer used in the above-described development step is not particularly limited, and known developer in the related art can be used. However, from the viewpoint of reducing the environmental load, it is preferable to use a developer containing 50% by mass or more of water (hereinafter, also abbreviated as "aqueous developer"). The developer may be an aqueous solution or a suspension (for example, an aqueous dispersion liquid).

In addition, a content of water contained in the aqueous developer is preferably 80% to 99.99% by mass and more preferably 90% to 99.9% by mass with respect to the total mass of the aqueous developer.

In the present invention, it is preferable that the aqueous developer contains a surfactant represented by Formula (2).

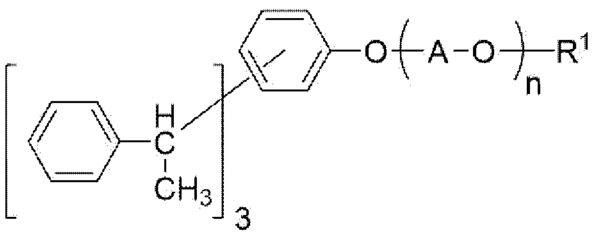

(2)

In Formula (2), A represents an alkylene group having 2 to 4 carbon atoms, $R^1$ represents a hydrogen atom or a substituent, and n represents an integer of 1 to 100. In a case where n is an integer of 2 to 100, a plurality of A's may be the same or different from each other.

A in Formula (2) represents an alkylene group having 2 to 4 carbon atoms, and is preferably an alkylene group having 2 or 3 carbon atoms and more preferably an ethylene group or an n-propylene group.

Examples of the substituent represented by one aspect of $R^1$ in Formula (2) include an alkyl group, an alkoxy group, an alkylcarbonyl group, an alkoxycarbonyl group, an alkylcarbonyloxy group, an alkylamino group, a dialkylamino group, an alkylamide group, an alkenyl group, an alkynyl group, a halogen atom, a cyano group, a nitro group, an alkylthiol group, and an N-alkyl carbamate group, and among these, an alkyl group is preferable.

As the alkyl group which is a suitable example of the substituent, for example, an alkyl group having 1 to 6 carbon atoms is preferable, and an alkyl group having 1 to 4 carbon atoms is more preferable. Specific examples thereof include a methyl group, an ethyl group, a propyl group, and an n-butyl group.

$R^1$ in Formula (2) represents a hydrogen atom or a substituent, and from the reason that the dispersibility of development scum is improved, $R^1$ is preferably a hydrogen atom.

n in Formula (2) represents an integer of 1 to 100, and from the reason that the dispersibility of development scum is improved, n is preferably an integer of 1 to 30, more preferably an integer of 5 to 20, and still more preferably an integer of 5 to 15.

[Rinse step]

It is preferable that the manufacturing method of a flexographic printing plate according to the embodiment of the present invention includes a rinse step of, after the above-described development step, rinsing surfaces of the non-image area and the image area formed in the above-described development step with water.

As a rinsing method in the rinse step, a method of washing with tap water, a method of spraying high pressure water, a method of rubbing the surfaces of the non-image area and the image area with a brush using a batch-type or transport-type brush type washing machine as a developing machine for flexographic printing plates mainly in the presence of water, and the like may be used.

Examples

Hereinafter, the present invention will be described in more detail with reference to examples. Materials, amounts used, ratios, treatment contents, treatment procedures, and the like shown in the following examples can be appropriately changed without departing from the spirit of the present invention. Therefore, the scope of the present invention should not be construed as being limited by the following examples.

[Example 1]

[Preparation of synthetic latex A]

465.0 g of water-dispersible latex (Nipol LX111NF, water-dispersible latex of polybutadiene, solid content: 55%, manufactured by Zeon Corporation) and 327.5 g of distilled water were added to a 1L three-neck flask, and the temperature was raised to 75°C with stirring under a nitrogen stream. After 30 minutes, an aqueous solution in which 9.6 g of 2,2'-azobis[N-(2-carboxyethyl)-2-methylpropionamidine] tetrahydrate (VA-057, manufactured by FUJIFILM Wako Chemical Corporation) as a water-soluble azo polymerization initiator had been dissolved in 65.0 g of distilled water was added thereto at once. After 3 hours, the temperature was raised to 90°C, and after another 6 hours, the mixture was allowed to cool to room temperature (23°C).

Next, the mixture was filtered through a non-woven filter paper (T-270, manufactured by ADVANTEC Co., Ltd.) to remove aggregates, thereby preparing a synthetic latex A having a concentration of solid contents of 30% by mass.

With regard to the synthetic latex A, in a case where a carbon-carbon double bond amount (hereinafter, also abbreviated as "surface C=C amount") on a surface of the water-dispersible particles was measured by the method described in paragraph [0016] of WO2020/158778A, it was 20 as shown in Table 1 below.

[Preparation of photosensitive resin composition]

103 parts by mass of the above-described synthetic latex A (solid content: 30%), 11 parts by mass of a telechelic polymer (BAC-45, manufactured by OSAKA ORGANIC CHEMICAL INDUSTRY LTD.; polybutadiene having acryloyloxy groups at both terminals, Mw = 10,000), and 9 parts by mass of 1,9-nonanediol dimethacrylate (NK ESTER NOD-N, Shin-Nakamura Chemical Co., Ltd.) were mixed with each other, and moisture was evaporated for 3 hours in a dryer heated to 60°C to obtain a mixture containing water-dispersible particles.

The mixture, 23 parts by mass of butadiene rubber (NF35R, manufactured by Asahi Kasei Corporation), 15 parts by mass of a plasticizer (Diana Process Oil PW-32, manufactured by Idemitsu Kosan Co., Ltd.), and 4 parts by mass of a surfactant (RAPISOL A-90, effective content: 90%, manufactured by NOF CORPORATION) were kneaded in a kneader set at 110°C for 45 minutes. Thereafter, 0.2 parts by mass of a thermal polymerization inhibitor and 8 parts by mass of a photopolymerization initiator (benzyl dimethyl ketal, manufactured by Tokyo Chemical Industry Co. Ltd.) were put into the kneader, and the mixture was kneaded for 5 minutes to obtain a photosensitive resin composition.

[Production of laminate for infrared ablation layer]

90.5 parts by mass of methyl ethyl ketone was added to 1.2 parts by mass of an infrared absorbing dye (CIR-RL, manufactured by Japan Carlit Co., Ltd.), 1.3 parts by mass of 2,2',4,4'-tetrahydroxybenzophenone (manufactured by FUJIFILM Wako Chemical Corporation), 2.6 parts by mass of curcumin (manufactured by FUJIFILM Wako Chemical Corporation), and 4.3 parts by mass of nitrocellulose (H1/8, manufactured by taihei chemicals limited), and the mixture was stirred until uniform to obtain a coating solution for a heat-sensitive image forming layer.

Next, the coating solution for a heat-sensitive image forming layer was applied onto one surface of a silica-containing PET film having a thickness of 75 μm (TOYOBO Ester (registered trademark) film U4, manufactured by TOYOBO Film Solution) [cover sheet] using a bar coater such that a thickness after drying was 1.4 μm, and then dried

for 2 minutes in an oven set at 90°C to obtain a heat-sensitive image forming layer.

Next, 51.8 parts by mass of acetone and 42.4 parts by mass of cyclopentanone were added to 1.3 parts by mass of the infrared absorbing dye (CIR-RL, manufactured by Japan Carlit Co., Ltd.) and 4.5 parts by mass of the nitrocellulose (H1/8, manufactured by taihei chemicals limited), and the mixture was stirred until uniform to obtain a coating solution for a barrier layer.

Next, the coating solution for a barrier layer was applied onto an upper surface of the above-described heat-sensitive image forming layer with a bar coater such that a thickness after drying was 0.4 μm, and then dried for 2 minutes in an oven set at 90°C to obtain a laminate for an infrared ablation layer, which had the cover sheet, the heat-sensitive image forming layer, and the barrier layer in this order.

The infrared absorbing dye CIR-RL (manufactured by Japan Carlit Co., Ltd.) was a compound having an absorption at a wavelength of 1070 nm, and a mass absorption coefficient at the wavelength of 1070 nm was 66.2 L/(g·cm) as shown in Table 1 below. The CIR-RL (manufactured by Japan Carlit Co., Ltd.) was the above-described compound represented by Formula (1).

[Production of flexographic printing plate precursor]

An adhesive was applied to one side of a PET film (substrate) having a thickness of 125 μm to form an adhesive layer on the substrate. The photosensitive resin composition prepared as described above was sandwiched between the above-described adhesive layer and the laminate for an infrared ablation layer on a side on which the heat-sensitive image forming layer was coated, and by pressing with a press heated to 80°C so that the thickness of the layer of the photosensitive resin composition (photosensitive resin layer) was 1.14 mm, a flexographic printing plate precursor including the substrate, the adhesive layer, the photosensitive resin layer, the barrier layer, and the heat-sensitive image forming layer in this order was produced.

[Examples 2 to 4 and Comparative Examples 1 and 2]

A flexographic printing plate precursor was produced according to the same procedure as in Example 1, except that the type and content (% by mass) of each component in the barrier layer were changed as shown in Table 1 below.

The ultraviolet absorber contained in the barrier layers of Example 2 and Comparative Example 1 was 2,2',4,4'-tetrahydroxybenzophenone as shown in Table 1 below, and the 2,2',4,4'-tetrahydroxybenzophenone was a compound having substantially no absorption in a wavelength range of 900 to 1200 nm and having an absorption in a wavelength range of 300 to 400 nm.

The third infrared absorbing dye contained in the barrier layer and the heat-sensitive image forming layer of Example 4 was IR-813 (p-toluenesulfonate) (manufactured by Tokyo Chemical Industry Co., Ltd.), and the IR-813 was a compound having an absorption at a wavelength of 830 nm. In the heat-sensitive image forming layer of Example 4, the amount of nitrocellulose was reduced by the amount of the third infrared absorbing dye added.

[Example 3]

A flexographic printing plate precursor was produced according to the same procedure as in Example 1, except that a photosensitive resin composition prepared by the following method was used.

[Preparation of photosensitive resin composition]

56 parts by mass of a commercially available Nipol LX111NF (solid content: 55, manufactured by ZEON CORPORATION), 11 parts by mass of a telechelic polymer (BAC-45, manufactured by OSAKA ORGANIC CHEMICAL INDUSTRY LTD.; polybutadiene having acryloyloxy groups at both terminals, Mw = 10,000), and 9 parts by mass of 1,9-nonanediol dimethacrylate (NK ESTER NOD-N, Shin-Nakamura Chemical Co., Ltd.) were mixed with each other, and moisture was evaporated for 3 hours in a dryer heated to 60°C to obtain a mixture containing water-dispersible particles.

The mixture, 23 parts by mass of butadiene rubber (NF35R, manufactured by Asahi Kasei Corporation), 15 parts by mass of a plasticizer (Diana Process Oil PW-32, manufactured by Idemitsu Kosan Co., Ltd.), and 4 parts by mass of a surfactant (RAPISOL A-90, effective content: 90%, manufactured by NOF CORPORATION) were kneaded in a kneader set at 110°C for 45 minutes. Thereafter, 0.2 parts by mass of a thermal polymerization inhibitor and 8 parts by mass of a photopolymerization initiator (benzyl dimethyl ketal, manufactured by Tokyo Chemical Industry Co. Ltd.) were put into the kneader, and the mixture was kneaded for 5 minutes to obtain a photosensitive resin composition.

Regarding the Nipol LX111NF, the surface C=C amount on a surface of the water-dispersible particles was 21.4 as shown in Table 1 below.

[Comparative Example 3]

A flexographic printing plate precursor was produced in the same manner as in Example 1, except that the laminate for an infrared ablation layer was changed to the following. Each component of the heat-sensitive image forming layer is also described in Table 1 below.

[Production of laminate for infrared ablation layer]

600 parts by mass of methyl isobutyl ketone was added to 50 parts by mass of an acrylic resin (Hi-pearl M5000, manufactured by Negami Chemical Industrial Co., Ltd.), 50 parts by mass of an elastomer (Nipol DN-101, NBR, manufactured by Zeon Corporation), and 100 parts by mass of carbon black (MA-8, manufactured by Mitsubishi Chemical Corporation) as an infrared absorbing pigment and mixed with a blade impeller, the obtained mixed solution was dispersed with a paint shaker, and then methyl isobutyl ketone was further added thereto so that the solid content was 15% by mass, thereby obtaining a polymer/carbon black dispersion liquid (coating solution for a heat-sensitive image forming layer).

Next, the coating solution for a heat-sensitive image forming layer was applied onto one surface of a silica-containing PET film having a thickness of 75 μm (TOYOBO Ester (registered trademark) film U4, manufactured by TOYOBO Film Solution) [cover sheet] using a bar coater such that a thickness after drying was 1.0 μm, and then dried for 1 minute in an oven set at 140°C to produce a laminate for an infrared ablation layer, which included the cover sheet and the heat-sensitive image forming layer and did not include the barrier layer.

In the carbon black (MA-8, manufactured by Mitsubishi Chemical Corporation) as an infrared absorbing pigment, a mass absorption coefficient at the wavelength of 1070 nm was 49 L/(g cm) as shown in Table 1 below.

[Table 1]

| | Photosensitive resin | | Barrier layer | | | | | | | | | Heat-sensitive image forming layer | | | | | | |
|---|---|---|---|---|---|---|---|---|---|---|---|---|---|---|---|---|---|---|
| | layer Latex | | infrared absorbing dye or pigment | | | Third infrared absorbing dye | | Ultraviolet absorber | | Binder | | Infrared absorbing dye or pigment | | | Third infrared absorbing dye | | Ultraviolet absorber | |
| | Type | Surface C=C amount | Type | Content (% by mass) | Mass absorption coefficient L/(gm·cm) | Type | Content (% by mass) | Type | % 6y mass | Type | % by mass | Type | Content (%by mass) | Mass absorption coefficient L/(gm·cm) | Type | Content (%by mass) | Type | %by mass |
| Example 1 | Synthetic latex A | 20 | CIR-RL (dye) | 22.3 | 66.2 | - | - | None | 0 | Nitrocellulose | 77.7 | CIR-RL (dye) | 12.8 | 66.2 | - | - | Benzophenone-based ※1 | 13.8 |
| Example 2 | Synthetic latex A | 20 | CIR-RL (dye) | 22.3 | 66.2 | - | - | Benzophenone-based ※ 1 | 0.09 | Nitrocellulose | 77.6 1 | CIR-RL (dye) | 12.8 | 66.2 | - | - | Benzophenone-based ※1 | 13.8 |
| Example 3 | Nipol LX111NF | 21.4 | CIR-RL (dye) | 22.3 | 66.2 | - | - | None | 0 | Nitrocellulose | 77.7 | CIR-RL (dye) | 12.8 | 66.2 | - | - | Benzophenone-based ※1 | 13.8 |
| Example 4 | Synthetic latex A | 20 | CIR-RL (dye) | 22.3 | 66.2 | IR-813 (dye) | 22.3 | None | 0 | Nitrocellulose | 55.4 | CIR-RL (dye) | 12.8 | 66.2 | | 12.8 | Benzophenone-based ※1 | 13.8 |
| Comparative Example 1 | Synthetic latex A | 20 | CIR-RL (dye) | 22.3 | 66.2 | - | - | Henzophenone-based ※1 | 0.1 | Nitrocellulose | 77.6 | CIR-RL (dye) | 12.8 | 66.2 | - | - | Henzophenonc-based ※1 | 13.8 |
| Comparative Example 2 | Synthetic latex A | 20 | None | 0 | 0 | - | - | None | 0 | Nitrocellulose | 100 | CIR-RL (dye) | 12.8 | 66.2 | - | - | Benzophenone-based ※1 | 13.8 |
| Comparative Example 3 | Synthetic latex A | 20 | - | - | - | - | - | - | - | - | - | MAS (pigment) | 50 | 49 | - | - | None (absorbed by MAS) | 0 |

※1: 2,2',4,4'-tetrahydroxybenzophenone

[Evaluation]

[Sensitivity]

The cover sheet of the produced flexographic printing plate precursor was peeled off, and then IR drawing was performed on the heat-sensitive image forming layer (including the barrier layer in Examples 1 and 2) using CDI Spark 2530 manufactured by ESKO.

The amount of light used for the drawing was changed in a range of 0 to 5.0 J/cm$^2$, and the amount of drawing light in a case where Dmin after the drawing was 0.07 or less was evaluated as the sensitivity. The results are shown in Table 2 below. As the value is smaller, the sensitivity is higher.

[White spots in line drawing]

From the substrate side of the produced flexographic printing plate precursor, exposure (back exposure) was performed for 15 seconds from a distance of 15 cm with an exposure device in which 15 fluorescent lamps of 40 W were arranged. Thereafter, using CDI Spark 2530 manufactured by ESKO, a negative pattern was formed on the heat-sensitive image forming layer of the laminate for an infrared ablation layer.

Thereafter, the laminate for an infrared ablation layer was exposed with the above-described exposure device for 8 minutes from the side of the laminate for the infrared ablation layer from a distance of 15 cm (main exposure). Thereafter, the laminate for an infrared ablation layer was peeled off, and development was performed for 10 minutes with a brush-type washing machine (liquid temperature: 50°C) containing an aqueous developer adjusted to have a concentration of sodium carbonate of 0.5% and a concentration of a surfactant (PIONINE D-6120, manufactured by TAKEMOTO OIL & FAT Co., Ltd.) (surfactant represented by Formula (2) described above; A: $-CH_2CH_2-$(ethylene group), $R^1$: hydrogen atom, n: 20) of 1%.

Thereafter, the obtained laminate was dried with hot air of 60°C until the moisture was removed. Thereafter, the photosensitive resin layer was exposed (post-exposed) with the above-described exposure device for 8 minutes from a distance of 15 cm to produce a flexographic printing plate.

Printing was performed using the above-described flexographic printing plate, and white spots in thin lines having a width of 200 μm were evaluated according to the following standard. The results are shown in Table 2 below.

<Evaluation standard>

A: no white spots
B: white spots were observed on a loupe, but could not be visually observed.
C: there were white spots which were visually observed.

[Manufacturing suitability]

The produced flexographic printing plate precursor was stored for 24 hours in an environment of 50°C and a relative humidity of 70%, and then the surface of the flexographic printing plate precursor was observed and evaluated according to the following standard. The results are shown in Table 2 below. A is preferable.

A: no crystal precipitate
B: with crystal precipitate

[Table 2]

| | Sensitivity | White spots in line drawing | Manufacturing suitability |
|---|---|---|---|
| | J/cm$^2$ | | |
| Example 1 | 1.0 | A | B |
| Example 2 | 1.0 | B | B |
| Example 3 | 1.0 | B | B |
| Example 4 | 1.0 | A | A |

(continued)

| | Sensitivity J/cm$^2$ | White spots in line drawing | Manufacturing suitability |
|---|---|---|---|
| Comparative Example 1 | 1.0 | C | B |
| Comparative Example 2 | 2.0 | C | B |
| Comparative Example 3 | 3.0 | C | A |

From the results shown in Tables 1 and 2 above, it was found that, in a case where the content of the compound (UV absorbing impurity) having substantially no absorption in a wavelength range of 900 to 1200 nm and having an absorption in a wavelength range of 300 to 400 nm in the barrier layer was 0.1% by mass with respect to the mass of the barrier layer, the sensitivity of the heat-sensitive image forming layer was high and good, but white spots occurred in the line drawing in a case of being used for a flexographic printing plate (Comparative Example 1).

In addition, in a case where the barrier layer containing no infrared absorbing dye was used, it was found that the sensitivity of the heat-sensitive image forming layer was deteriorated, and white spots occurred in the line drawing in a case of being used for a flexographic printing plate (Comparative Example 2).

In addition, in a case where the barrier layer was not provided and the heat-sensitive image forming layer containing the infrared absorbing pigment not corresponding to the infrared absorbing dye was used, it was found that the sensitivity of the heat-sensitive image forming layer was further deteriorated, and white spots occurred in the line drawing in a case of being used for a flexographic printing plate (Comparative Example 3).

On the other hand, in a case where both of the barrier layer and the heat-sensitive image forming layer contained the infrared absorbing dye, and the content of (UV absorbing impurity) in the barrier layer was 0% by mass or more and less than 0.1% by mass with respect to the mass of the barrier layer, it was found that the sensitivity of the heat-sensitive image forming layer was high, and the occurrence of white spots in the line drawing could be suppressed in a case of being used for a flexographic printing plate (Examples 1 to 4).

In particular, from the comparison between Example 1 and Example 3, in a case where the surface C=C amount of the water-dispersible particles contained in the photosensitive resin layer was 21 or less, it was found that the occurrence of white spots in the line drawing could be further suppressed in a case of being used for a flexographic printing plate.

In addition, from the comparison between Example 1 and Example 2, in Example 1 in which the content of the UV absorbing impurity in the barrier layer was 0.05% by mass or less with respect to the mass of the barrier layer, the occurrence of white spots was further suppressed.

In addition, from the comparison between Example 1 and Example 4, in Example 4 in which both the barrier layer and the heat-sensitive image forming layer contained the third infrared absorbing dye having an absorption at a wavelength of 830 nm, the manufacturing suitability was more excellent.

Explanation of References

1: support
2: image forming layer
2a: floor
2b, 2c: exposed portion
2d: weakly exposed portion
2e: end part
3: barrier layer
3a: residue of barrier layer
4: heat-sensitive image forming layer
4a: residue of heat-sensitive image forming layer
5: cover sheet
10: flexographic printing plate precursor

## Claims

**1.** A flexographic printing plate precursor comprising, in the following order:

a support;
a photosensitive resin layer;
a barrier layer; and
a heat-sensitive image forming layer,
wherein the barrier layer contains a first infrared absorbing dye,
the heat-sensitive image forming layer contains an ultraviolet absorber and a second infrared absorbing dye, and
in the barrier layer, a content of a compound having substantially no absorption in a wavelength range of 900 to 1200 nm and having an absorption in a wavelength range of 300 to 400 nm is 0% by mass or more and less than 0.1% by mass with respect to a mass of the barrier layer.

**2.** The flexographic printing plate precursor according to claim 1,
wherein both of the first infrared absorbing dye and the second infrared absorbing dye are a compound having an absorption at a wavelength of 1070 nm and having a mass absorption coefficient at the wavelength of 1070 nm of 50 L/(g cm) or more.

**3.** The flexographic printing plate precursor according to claim 2,
wherein both of the first infrared absorbing dye and the second infrared absorbing dye are a compound represented by Formula (1),

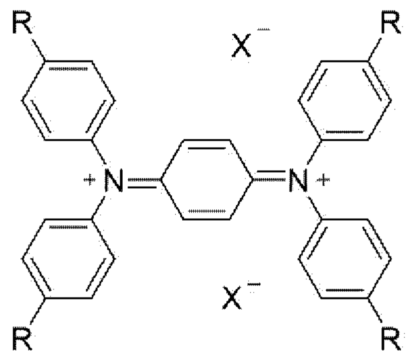

(1)

here, in Formula (1),

R represents a monovalent organic group, where a plurality of R's may be the same or different from each other, and
$X^-$ represents a monovalent anion, where a plurality of $X^-$'s may be the same or different from each other.

**4.** The flexographic printing plate precursor according to claim 2 or 3,
wherein both of the barrier layer and the heat-sensitive image forming layer contain a third infrared absorbing dye having an absorption at a wavelength of 830 nm.

**5.** The flexographic printing plate precursor according to any one of claims 1 to 4,

wherein the photosensitive resin layer contains a monomer, a polymerization initiator, a base polymer, and water-dispersible particles,
the water-dispersible particles have a carbon-carbon double bond, and
a carbon-carbon double bond amount on a surface of the water-dispersible particles is 21 or less.

**6.** A manufacturing method of a flexographic printing plate having a non-image area and an image area, the manufacturing method comprising:

a mask forming step of, with respect to the flexographic printing plate precursor according to any one of claims 1 to 4, forming an image on the heat-sensitive image forming layer included in the flexographic printing plate precursor to form a mask;
an exposure step of, after the mask forming step, imagewise exposing the photosensitive resin layer included in the flexographic printing plate precursor through the mask; and
a development step of, after the exposure step, performing development using a developer to form a non-image

area and an image area.

**7.** The manufacturing method of a flexographic printing plate according to claim 6, wherein the developer contains 50% by mass or more of water.

**8.** The manufacturing method of a flexographic printing plate according to claim 6 or 7, wherein the developer contains a surfactant represented by Formula (2),

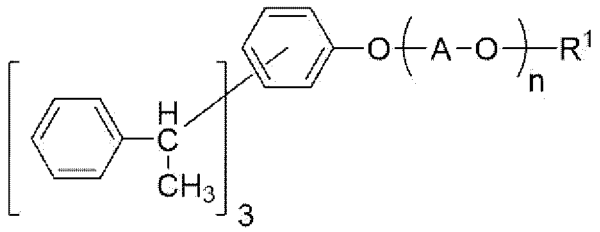

(2)

here, in Formula (2),
A represents an alkylene group having 2 to 4 carbon atoms, $R^1$ represents a hydrogen atom or a substituent, and n represents an integer of 1 to 100, in which in a case where n is an integer of 2 to 100, a plurality of A's may be the same or different from each other.

FIG. 1

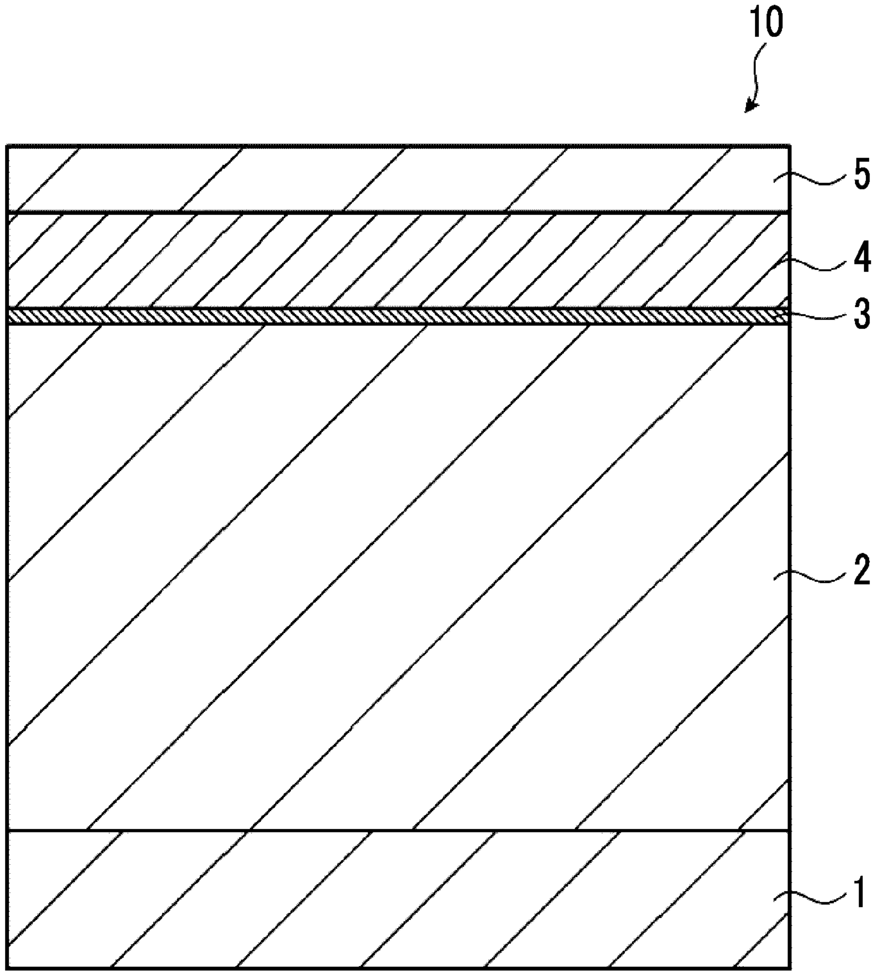

FIG. 2A

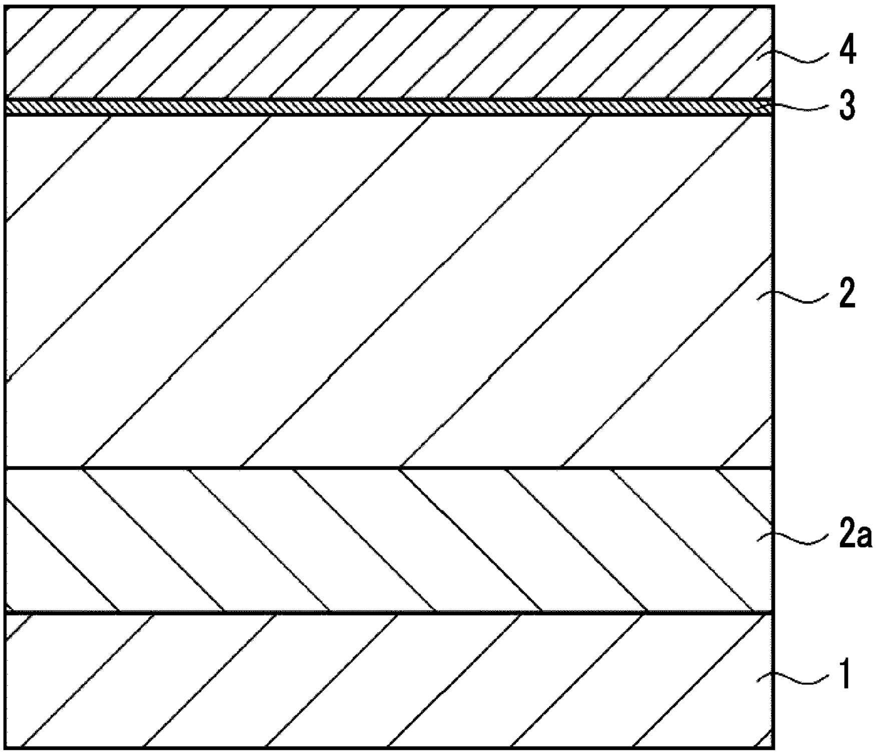


FIG. 2B

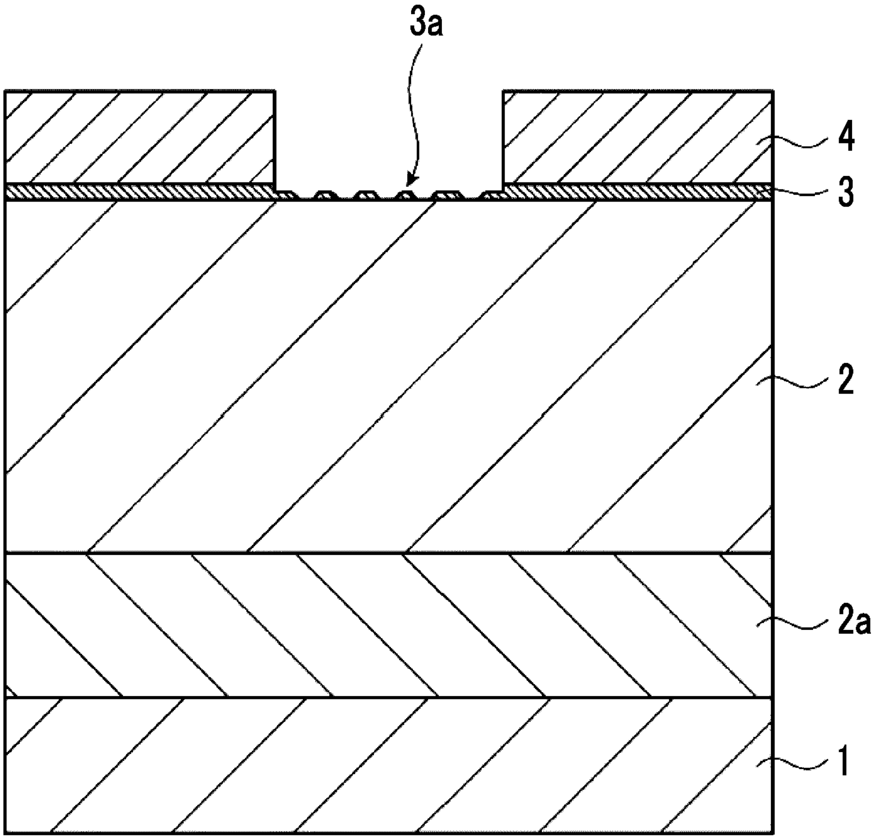

FIG. 2C

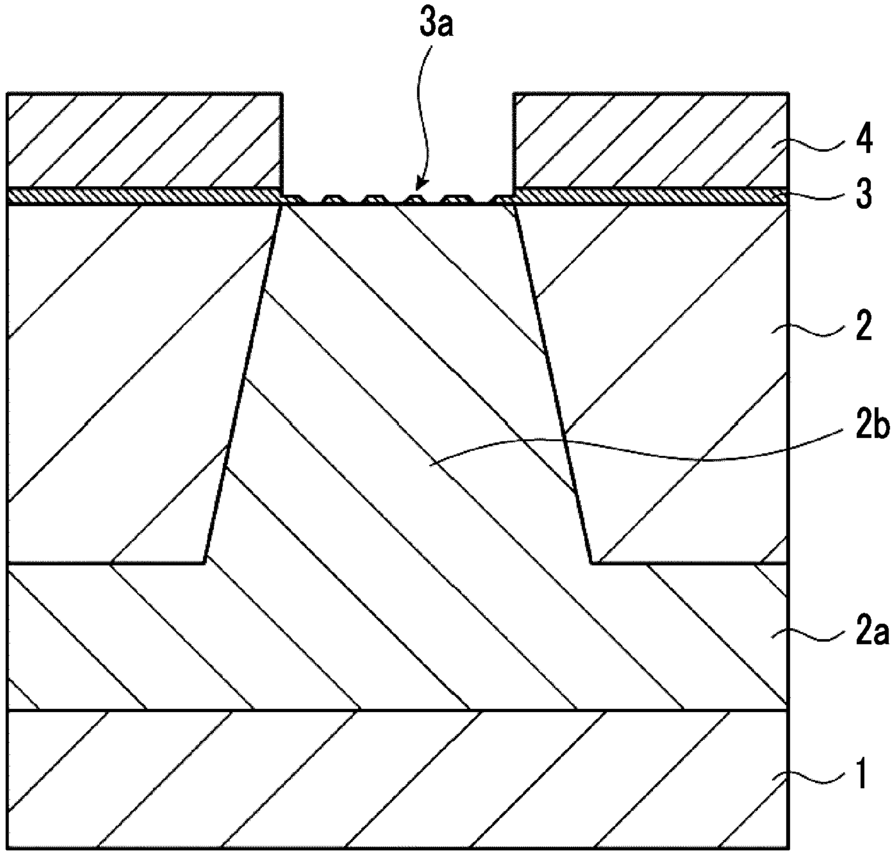


FIG. 2D

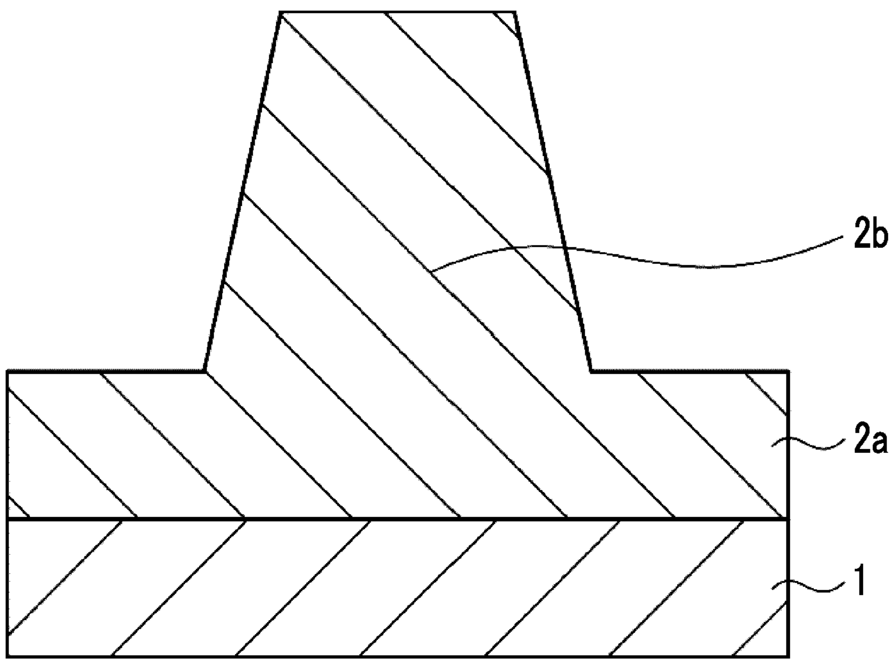

FIG. 3A

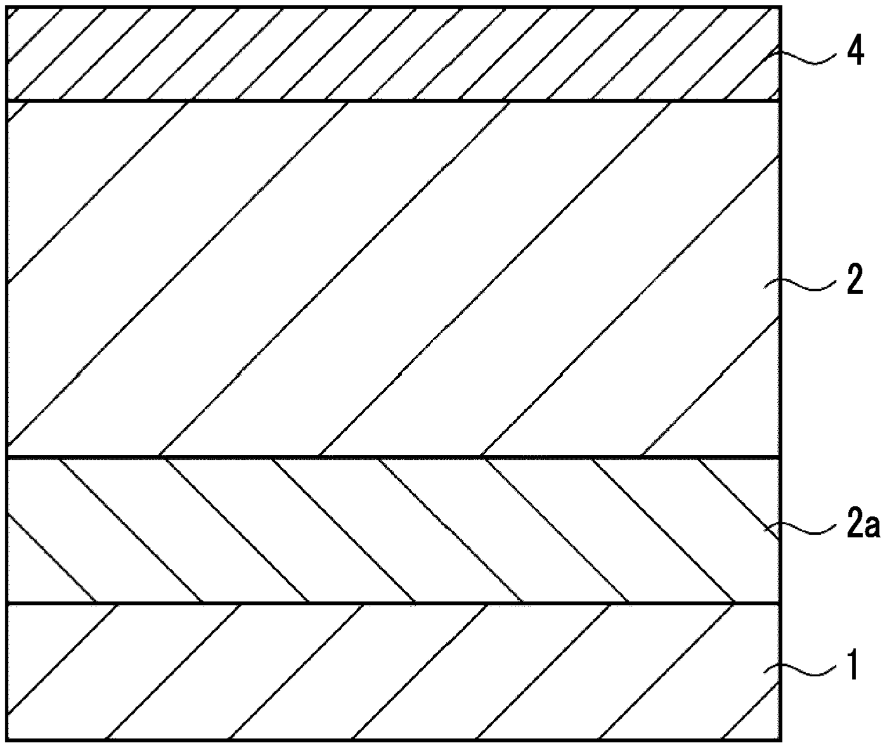


FIG. 3B

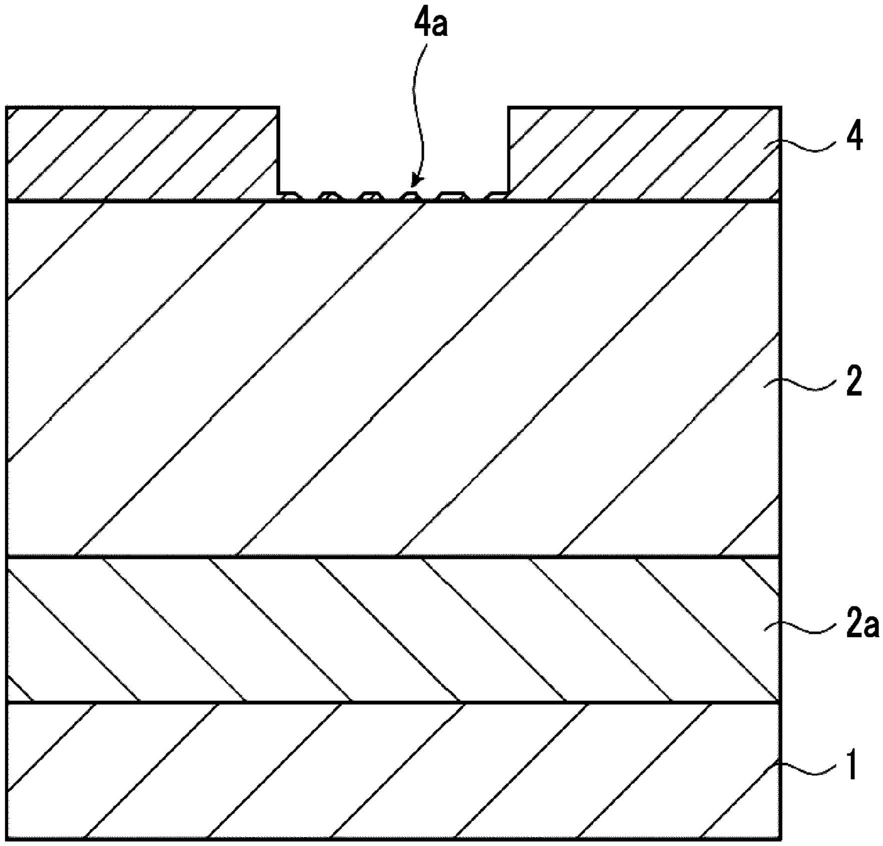

FIG. 3C

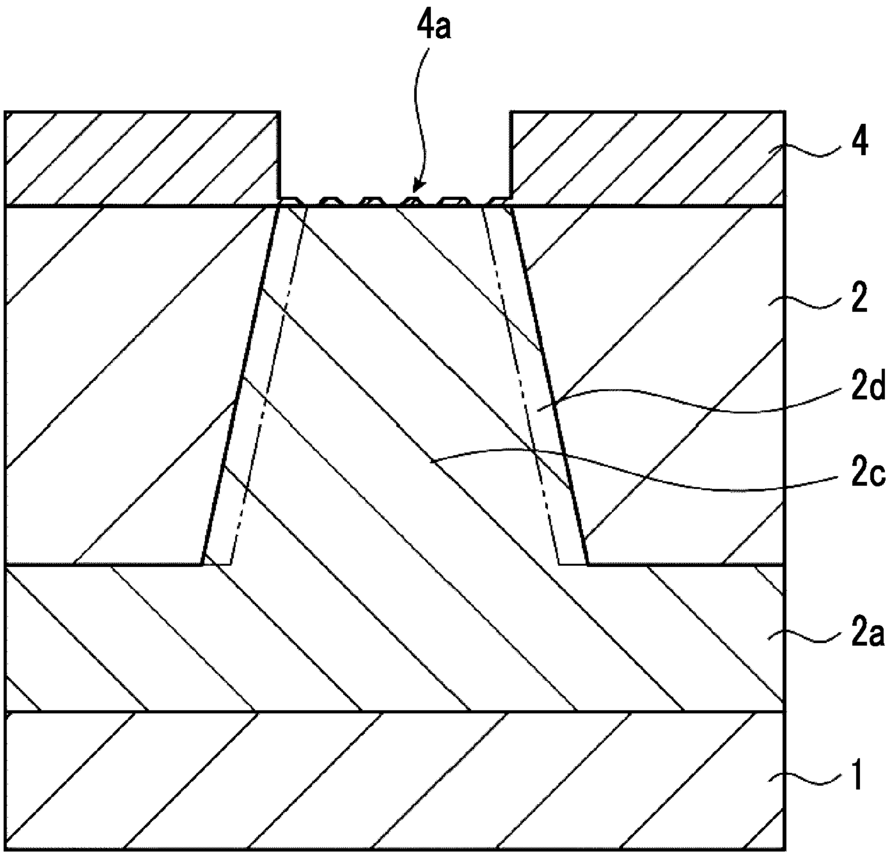


FIG. 3D

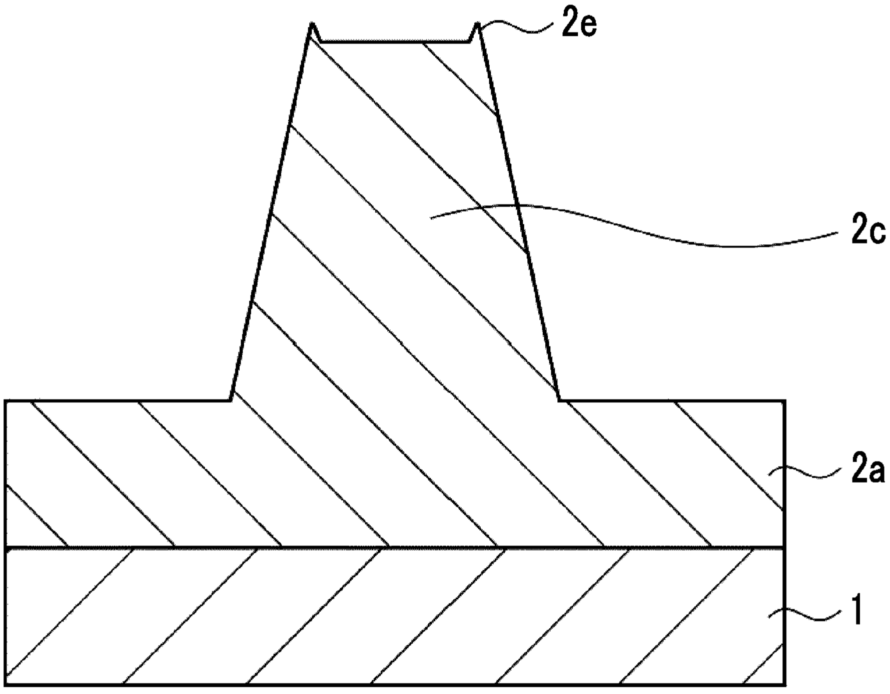

## INTERNATIONAL SEARCH REPORT

International application No. **PCT/JP2021/047547**

**A. CLASSIFICATION OF SUBJECT MATTER**

***G03F 7/00***(2006.01)i; ***G03F 7/095***(2006.01)i
FI: G03F7/095; G03F7/00 502

According to International Patent Classification (IPC) or to both national classification and IPC

**B. FIELDS SEARCHED**

Minimum documentation searched (classification system followed by classification symbols)

G03F7/00; G03F7/095

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2016-532135 A (FLINT GROUP GERMANY GMBH) 13 October 2016 (2016-10-13) claims, paragraphs [0050], [0058], [0078], [0100]-[0147] | 1, 4, 6-8 |
| A | | 2-3, 5 |
| A | JP 2016-524718 A (EASTMAN KODAK CO.) 18 August 2016 (2016-08-18) examples | 1-8 |
| A | JP 2010-531462 A (EASTMAN KODAK CO.) 24 September 2010 (2010-09-24) examples | 1-8 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **07 March 2022** | **15 March 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2021/047547**

| Patent document cited in search report | Publication date (day/month/year) | Patent family member(s) | Publication date (day/month/year) |
|---|---|---|---|
| JP 2016-532135 A | 13 October 2016 | US 2016/0229172 A1<br>claims, paragraphs [0068], [0078], [0104], [0127]-[0185]<br>CA 2923703 A | |
| JP 2016-524718 A | 18 August 2016 | US 2014/0315129 A1<br>examples<br>EP 2987030 A1<br>CN 105143980 A | |
| JP 2010-531462 A | 24 September 2010 | US 2008/0305407 A1<br>examples<br>EP 2153278 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012137515 A
- JP 2011038007 A
- WO 2020158778 A